# EUROPEAN PATENT APPLICATION

(11) **EP 4 177 958 A2**
(43) Date of publication of application: **10.05.2023**
(21) Application number: 22200260.2
(22) Date of filing: 07.10.2022
(51) Int. Cl.: H01L 29/775, H01L 29/417, H01L 29/423, H01L 29/06, H01L 21/336, H01L 27/06, H01L 21/768, H01L 21/283, H01L 21/20, B82Y 10/00

(54) **LAYER TRANSFER PROCESS TO FORM BACKSIDE CONTACTS IN SEMICONDUCTOR DEVICES**

(30) Priority: 09.11.2021 US 202117522342
(71) Applicant: Intel Corporation, Santa Clara, CA 95054 (US)
(72) Inventor: Thomas, Nicole K., Portland, 97209 (US); Agrawal, Ashish, Hillsboro, 97124 (US); Dewey, Gilbert, Beaverton, 97006 (US); Huang, Cheng-Ying, Hillsboro, 97124 (US); Mannebach, Ehren, Tigard, 97223 (US); Rachmady, Willy, Beaverton, 97007 (US); Radosavljevic, Marko, Portland, 97229 (US)
(74) Representative: Goddar, Heinz J.

(57) **Abstract**

Techniques are provided herein to form semiconductor devices having backside contacts. Sacrificial plugs are formed first within a substrate at particular locations to align with source and drain regions during a later stage of processing. Another wafer is subsequently bonded to the surface of the substrate and is thinned to effectively transfer different material layers to the top surface of the substrate. One of the transferred layers acts as a seed layer for the growth of additional semiconductor material used to form semiconductor devices. The source and drain regions of the semiconductor devices are sufficiently aligned over the previously formed sacrificial plugs. A backside portion of the substrate may be removed to expose the sacrificial plugs from the backside. Removal of the plugs and replacement of the recesses left behind with conductive material forms the conductive backside contacts to the source or drain regions.

## Description

### FIELD OF THE DISCLOSURE

The present disclosure relates to integrated circuits, and more particularly, to backside contacts for semiconductor devices.

### BACKGROUND

As integrated circuits continue to scale downward in size, a number of challenges arise. For instance, reducing the size of memory and logic cells or otherwise increasing transistor density is becoming increasingly more difficult. One possible solution that can be used to allow further scaling includes the use of backside contacts. For instance, use of backside contacts can reduce the density and complexity for frontside interconnects. However, there remain a number of non-trivial challenges with respect to forming backside connections.

### BRIEF DESCRIPTION OF THE DRAWINGS

Figures 1A and 1B are cross-sectional views of a semiconductor device that includes backside contacts and a multilayer sub fin structure, in accordance with an embodiment of the present disclosure.
Figures 2A - 2N are cross-section views that collectively illustrate various stages in an example process for forming backside contacts through the use of a layer transfer technique, in accordance with an embodiment of the present disclosure.
Figure 3 illustrates a cross-section view of a semiconductor device having a stacked transistor arrangement that includes both frontside and backside contacts, in accordance with an embodiment of the present disclosure.
Figure 4 illustrates a cross-section view of a chip package containing one or more semiconductor dies, in accordance with some embodiments of the present disclosure.
Figure 5 is a flowchart of a fabrication process for semiconductor devices having backside contacts formed using a layer transfer technique, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines (e.g., tapered sidewalls and/or rounded corners), right angles, and some features may have surface topology or otherwise be non-smooth, given real world limitations of the processing equipment and techniques used.

### DETAILED DESCRIPTION

Techniques are provided herein to form semiconductor devices having backside contacts. In an embodiment, backside contacts are formed using a layer transfer technique. In more detail, rather than forming sacrificial plugs deep within the source or drain trenches adjacent to a semiconductor fin, sacrificial plugs are formed first within a substrate at particular locations to align with source and drain regions during a later stage of processing. Subsequently, another wafer is bonded to the surface of the substrate and is thinned to effectively transfer different material layers to the top surface of the substrate that includes the earlier-formed sacrificial plugs. In some embodiments, a thin semiconductor layer and an oxide layer are formed on the top surface of the substrate using the layer transfer technique. The thin semiconductor layer acts as a seed layer for the growth of additional semiconductor material used to form semiconductor fins. The source and drain regions adjacent to a given semiconductor fin are aligned over the previously formed sacrificial plugs. A bulk backside portion of the substrate may be removed to expose the sacrificial plugs from the backside. The plugs can then be removed (e.g., by selective etch) and replaced with conductive material thereby forming the conductive backside contacts to the source or drain regions. The channel region between the source and drain regions can be, for example, a fin (e.g., suitable for double-gate and tri-gate transistor configurations) or multilayer fin (e.g., suitable for gate-all-around transistor configurations) or other semiconductor body. The techniques can be used in two-dimensional (2D) integrated circuit architecture or three-dimensional (3D) integrated circuit architecture. Numerous variations and embodiments will be apparent in light of this disclosure.

### General Overview

As previously noted, backside contacts can be used to reduce the density and complexity for frontside interconnects. By providing interconnects on the frontside and backside of semiconductor devices, a greater density of devices can be achieved on the die. However, the formation of such backside contacts come with many challenges. In more detail, one possible process is where sacrificial plugs are formed at the bottom of the source and drain trenches, prior to epitaxial growth of the source and drain regions. These sacrificial plugs can be removed layer during backside substrate processing. After such removal, the recesses left behind are filled with conductive material to form the backside contacts. However, due to the high-aspect ratios of the source and drain trenches, the etch recess used to determine the final height of the sacrificial plugs at the bottom of the trenches can yield non-uniform sacrificial plug heights. Moreover, such processing can adversely impact existing features, such as the case where the dummy gate structure bends or otherwise deforms as the laterally adjacent source and drain recesses are etched to a relatively deep depth.

Thus, and in accordance with an embodiment of the present disclosure, techniques are provided herein to form backside contacts earlier in the fabrication process and before any high-aspect ratio structures are formed that can negatively impact their formation or previously-formed features. According to some embodiments, sacrificial plugs are formed within the top surface of a substrate at a given pitch or pattern, such that the plugs will sufficiently align over source or drain trenches formed later in the process. Accordingly, the pitch can vary depending on the desired gate length of the semiconductor devices. Subsequently, a semiconductor wafer having a top oxide layer is bonded to the top surface of the substrate and over the sacrificial plugs. The semiconductor wafer is thinned down, for instance, until only a thin layer of semiconductor material remains over the oxide layer, according to some embodiments. Thus, a layer transfer process occurs where a layer of oxide and a layer of semiconductor material are transferred onto the top surface of the substrate that contains the sacrificial plugs. The layer of semiconductor material can act as a seed layer for further growth of semiconductor material used to form the semiconductor devices (e.g., finFETs, gate-all-around (GAA) devices, forksheet devices, etc.) The source and drain regions are formed within trenches that are over corresponding sacrificial plugs in the substrate. Frontside gate processing can be carried out in a gate-first or gate-last process, and may include the formation of any sutiable gate structures depending on the channel configuration (e.g., tri-gate, double-gate, GAA). As previously noted, 2D and 3D transistor architecture can be used. Once the formation of front-end-of-the-line (FEOL) structures is complete, the resulting overall integrated circuit structure can be inverted, and the backside bulk portion of the substrate may be removed to expose the backside of the sacrificial plugs. The sacrificial plugs may be removed and replaced with conductive material to form the backside contacts. Due to the layer transfer process, the oxide and thin semiconductor layer will remain in the sub fin portion of the semiconductor devices, according to some embodiments. In some other cases, backside gate processing may be carried out as well (for 2D or 3D architectures), such that at least some of the oxide and thin semiconductor layer is removed in the sub fin portion of the semiconductor devices. In some such cases, one or more remnants of the oxide and thin semiconductor layer may remain (e.g., under the gate spacer on one or both sides).

According to an embodiment, an integrated circuit includes: a base dielectric layer; a semiconductor device over the a base dielectric layer that includes a semiconductor material extending between a source region and a drain region and a sub fin beneath the semiconductor material, a first dielectric layer adjacent to the sub fin of the semiconductor device; and a conductive contact in the base dielectric layer and contacting the source region or the drain region from beneath the source region or the drain region. In some such cases, the sub fin includes a semiconductor layer over a second dielectric layer.

According to an embodiment, an electronic device includes a chip package having one or more dies. At least one of the one or more dies includes a semiconductor device that includes: a semiconductor material extending between a source region and a drain region and a sub fin beneath the semiconductor material; a first dielectric layer adjacent to the sub fin of the semiconductor device; and a conductive contact configured to contact the source region or the drain region from beneath the source region or the drain region. In some such cases, the sub fin includes a semiconductor layer over a second dielectric layer.

According to another embodiment, an integrated circuit includes a first semiconductor device and a second semiconductor device. The first semiconductor device includes first semiconductor material extending between a first source region and a first drain region, a sub fin beneath the first semiconductor material, and a first gate structure around the first semiconductor material. The second semiconductor device includes second semiconductor material extending between a second source region and a second drain region, and a second gate structure around the second semiconductor material. The second semiconductor device is located vertically over the first semiconductor device. The integrated circuit further includes a gate isolation layer between the first gate structure and the second gate structure, a first conductive contact configured to contact the first source region or the first drain region from beneath the first source region or the first drain region, and a second conductive contact configured to contact the second source region or the second drain region from above the second source region or the second drain region. In some such cases, the sub fin includes a semiconductor layer over a dielectric layer. In some cases, a monolithic gate structure is around both the first and second semiconductor material, rather than a split-gate structure having first and second gate structures separated by an isolation layer.

According to another embodiment, a method of forming an integrated circuit includes forming one or more recesses into a first surface of a first substrate; forming a sacrificial material within the one or more recesses to form one or more material plugs; providing a second substrate having a semiconductor material and an oxide layer on a top surface of the second substrate; bonding the second substrate to the first substrate by forming a bond between the oxide layer and the first surface of the first substrate; removing a portion of the second substrate such that only the oxide layer and a single layer of the semiconductor material on the oxide layer remains, the single layer of semiconductor material having a thickness of less than, for example, 100 nm; forming one or more additional layers of semiconductor material over the single layer of semiconductor material; and etching one or more recesses through the one or more additional layers and the single layer of semiconductor material, wherein a given recess of the one or more recesses exposes a corresponding material plug of the one or more material plugs. Source or drain or diffusion regions can be formed in the one or more recesses and on the plug material. The plug material can be subsequently removed via a selective etch and replaced with contact material, to provide backside one or more contacts.

The techniques can be used with any type of non-planar transistors, including finFETs (sometimes called double-gate transistors, or tri-gate transistors), or nanowire and nanoribbon and nanosheet transistors (sometimes called GAA transistors or forksheet transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a multilayer structure within the sub fin portion of a given semiconductor device. In some embodiments, the multilayer structure includes a dielectric layer between two semiconductor layers. One of the two semiconductor layers may be an integral part of the substrate. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "backside" generally refers to the area beneath one or more semiconductor devices (below the device layer) either within the device substrate or in the region of the device substrate (in the case where the bulk of the device substrate has been removed). Note that the backside may become a frontside, and vice-versa, if a given structure is flipped. To this end, and as will be appreciated, the use of terms like "above" "below" "beneath" "upper" "lower" "top" and "bottom" are used to facilitate discussion and are not intended to implicate a rigid structure or fixed orientation; rather such terms merely indicate spatial relationships when the structure is in a given orientation.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

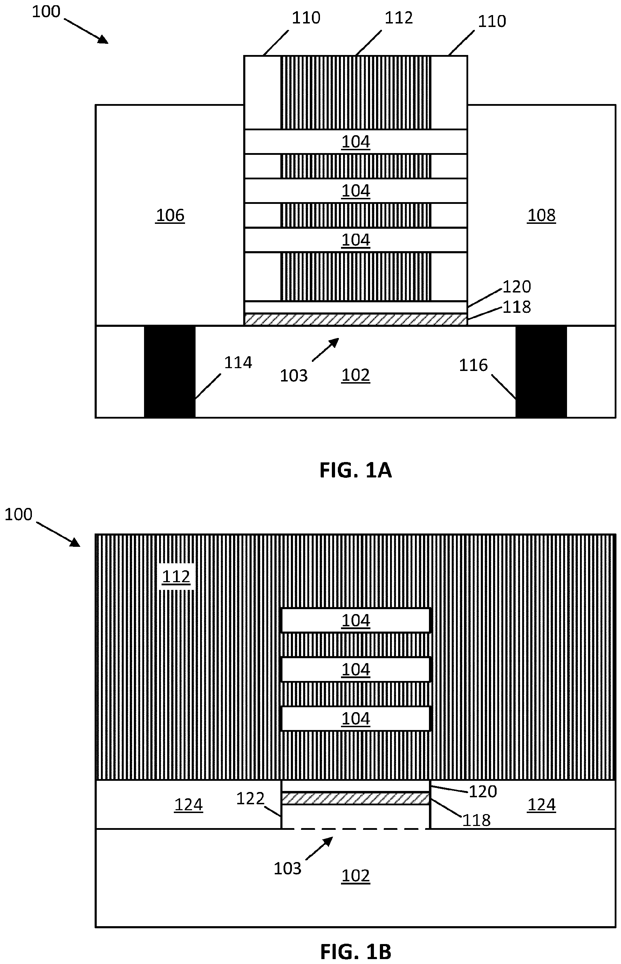

Figure 1A is a cross-sectional view taken across an example semiconductor device 100, according to an embodiment of the present disclosure. Figure 1B is another cross-sectional view of the same semiconductor device taken in the orthogonal direction through the center of the device. Semiconductor device 100 may be any type of non-planar metal oxide semiconductor (MOS) transistor, such as a tri-gate, gate-all-around (GAA), or forksheet transistor, although other transistor topologies and types could also benefit from the techniques provided herein. The illustrated embodiments herein use the GAA structure. Semiconductor device 100 represents a portion of an integrated circuit that may contain any number of similar semiconductor devices.

As can be seen, semiconductor device 100 is formed over a dielectric base layer 102. According to some embodiments, dielectric base layer 102 is formed after the removal of a substrate during backside processing, as will be described in more detail herein. Dielectric base layer 102 may be any suitable dielectric material, such as silicon dioxide, aluminum oxide, or silicon oxycarbonitride.

Semiconductor device 100 includes a sub fin region 103 and a semiconductor region that includes a plurality of nanoribbons 104 above the sub fin region 103. According to some embodiments, at least a portion of sub fin region 103 comprises the same dielectric material as dielectric base layer 102. According to some embodiments, nanoribbons 104 extend between a source region 106 and a drain region 108 to provide an active region for a transistor (e.g., the semiconductor region beneath the gate). Figure 1A also illustrates spacer structures 110 around both ends of nanoribbons 104 as would be understood to a person skilled in the relevant art. Spacer structures 110 may include a dielectric material, such as silicon nitride.

According to some embodiments, source and drain regions 106 and 108 are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. Any number of source and drain configurations and materials can be used.

According to some embodiments, the fins or semiconductor material can be formed of material deposited over an underlying substrate. In one such example case, a blanket layer of silicon germanium (SiGe) can be deposited over a silicon substrate, and then patterned and etched to form a plurality of SiGe fins or nanoribbons. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches.

A gate structure 112 is provided over each of nanoribbons 104 between spacer structures 110. Gate structure 112 includes both a gate dielectric around the corresponding nanoribbons and a gate electrode over the gate dielectric. The gate dielectric may also be deposited along sidewalls and the bottom of the trench between spacer structures 110. The gate dielectric may include a single material layer or multiple stacked material layers. In some embodiments, the gate dielectric includes a first dielectric layer such as silicon oxide and a second dielectric layer that includes a high-K material such as hafnium oxide. The hafnium oxide may be doped with an element to affect the threshold voltage of the given semiconductor device. According to some embodiments, the doping element used in the gate dielectric is lanthanum.

According to some embodiments, gate structure 112 includes a gate electrode that extends over the gate dielectric around each of nanoribbons 104. The gate electrode may include any sufficiently conductive material such as a metal, metal alloy, or doped polysilicon. According to some embodiments, the gate electrode may be interrupted between any other semiconductor devices by a gate cut structure. In some embodiments, the gate electrode includes one or more work function metals around the corresponding nanoribbons. For example, semiconductor device 100 may be a p-channel device that includes n-type dopants within nanoribbons 104 and includes a work function metal having titanium around nanoribbons 104. In another example, semiconductor device 100 is an n-channel device that includes p-type dopants within nanoribbons 104 and includes a work function metal having tungsten around nanoribbons 104. In some embodiments, the gate electrode includes a fill metal or other conductive material around the work function metal(s) to provide the whole gate electrode structure.

According to some embodiments, one or more buried conductive layers 114 and 116 are provided within base dielectric layer 102. In the illustrated example, buried conductive layer 114 is provided within a portion of base dielectric layer 102 and coupled to a backside of source region 106 and buried conductive layer 116 is provided within a portion of base dielectric layer 102 and coupled to a backside of drain region 108. Each of buried conductive layers 114 and 116 can be any conductive material, such as any metal or metal alloy, that may include any of tungsten, molybdenum, ruthenium, cobalt, copper, aluminum, or silver. Note that conductive layers 114 and 116 are also referred to herein as backside contacts.

According to some embodiments, sub fin 103 includes different material layers over one another. For example, sub fin 103 may include a dielectric layer 118 and a semiconductor layer 120 over dielectric layer 118. As seen more clearly in Figure 1B, a dielectric portion 122 of sub fin 103 may be an integral part of base dielectric layer 102, while dielectric layer 118 is over dielectric portion 122. Accordingly, in some embodiments, dielectric layer 118 is arranged between semiconductor layer 120 and dielectric portion 122. Dielectric portion 122 and dielectric layer 118 may include the same dielectric material. In some embodiments, dielectric layer 118 is an oxide of the semiconductor material of semiconductor layer 120. In some examples, semiconductor layer 120 includes silicon while both dielectric layer 118 and dielectric portion 122 includes silicon oxide. In some embodiments, semiconductor layer 120 includes silicon and germanium (SiGe). According to some embodiments, semiconductor layer 120 has a single-crystalline lattice structure. Dielectric layer 118 may have a thickness between about 5 nm and about 20 nm. Semiconductor layer 120 may have a thickness between about 10 nm and about 30 nm. According to some embodiments, each of source region 106 and drain region 108 contacts both dielectric layer 118 and semiconductor layer 120.

As can further be seen, another dielectric layer 124 that may include silicon oxide, or any other suitably insulating material, is formed adjacent to sub fin 103. Dielectric layer 124 provides shallow trench isolation (STI) between any adjacent semiconductor devices. Dielectric layer 124 can be any suitable dielectric material, such as silicon dioxide, aluminum oxide, or silicon oxycarbonitride. According to some embodiments, dielectric layer 124 includes the same dielectric material as base dielectric layer 102. In some embodiments, a depth of each of buried conductive layers 114 and 116 is greater than the vertical thickness of dielectric portion 122 of sub fin 103 (e.g., buried conductive layers 114 and 116 extend below the bottom surface of dielectric layer 124).

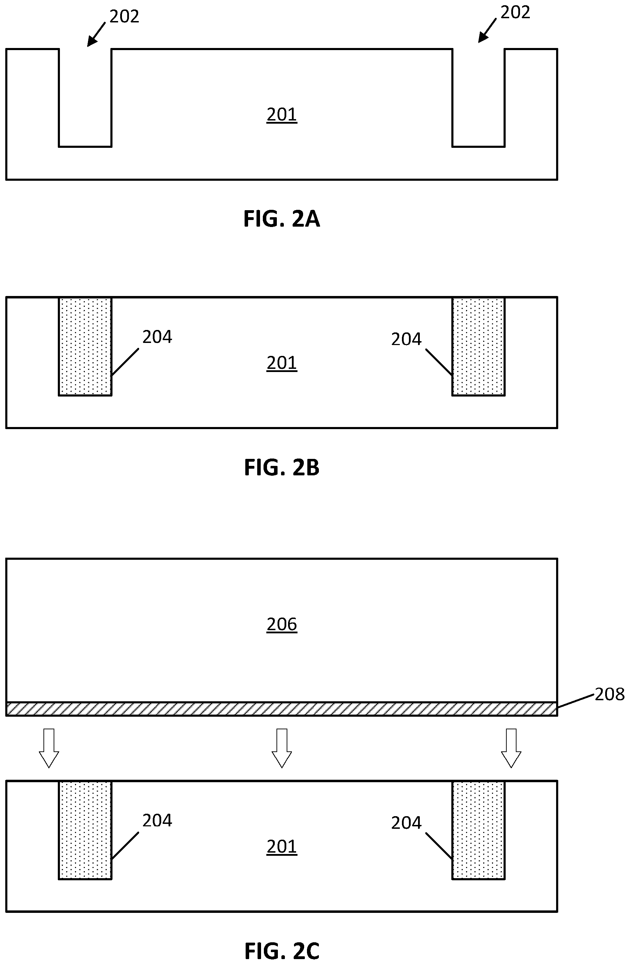

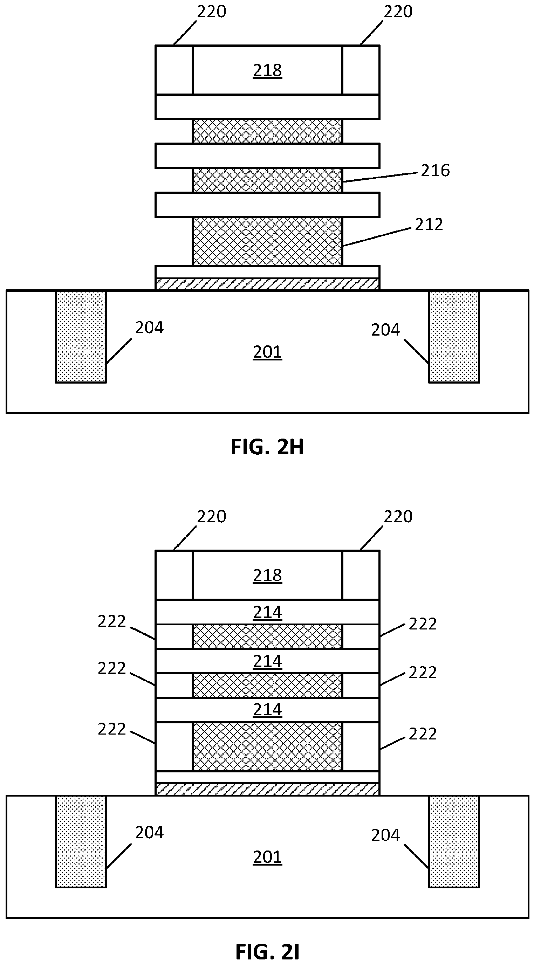

Note that conductive layers 114 and 116 can be coupled to one or more additional backside conductive layers that are a part of one or more stacked interconnect layers formed on the backside of the device, according to some examples. The multi-layer sub fin 103 is created due to the layer transfer process used to fabricate semiconductor device 100 as described in more detail with reference to Figures 2A - 2N.

### Fabrication Methodology

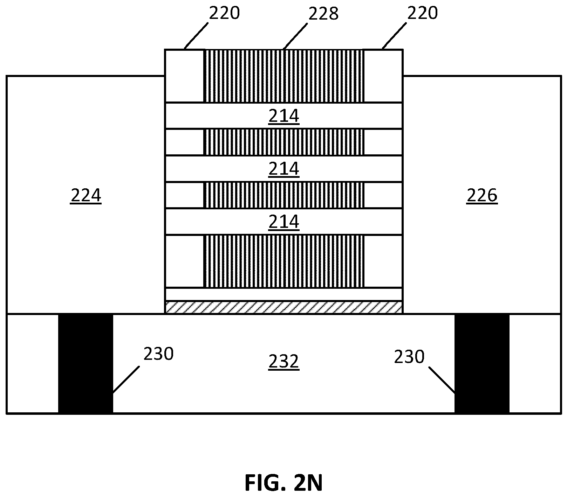

Figures 2A - 2N include cross-sectional views that collectively illustrate an example process for forming an integrated circuit configured with semiconductor devices having backside contacts, in accordance with an embodiment of the present disclosure. Each figure shows an example structure that results from the process flow up to that point in time, so the depicted structure evolves as the process flow continues, culminating in the structure shown in Figure 2N, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a substrate 201 after forming recesses 202 through the top surface of substrate 201, according to an embodiment of the present disclosure. Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

Recesses 202 are formed in locations where the backside contacts will later be formed. Accordingly, recesses 202 may have a pitch dependent on a desired transistor gate length. In some examples, recesses 202 have a pitch between about 50 nm and about 100 nm. Although only two recesses 202 are illustrated, it should be understood that any number of recesses 202 can be formed in substrate 201 to form any number of backside contacts.

While dimensions can vary from one example embodiment to the next, a depth of a given recess 202 may be between about 30 nm and about 100 nm while a width of a given recess may be between about 5 nm and about 50 nm. Substrate 201 is not drawn to scale, such that a total thickness of substrate 201 is orders of magnitude greater than the depths of recesses 202. For example, substrate 201 may have a total thickness between 100 µm and 500 µm.

Figure 2B depicts the cross-section view of the structure shown in Figure 2B following the formation of sacrificial plugs 204 within recesses 202, according to an embodiment of the present disclosure. Sacrificial plugs 204 may include any material that have a high degree of etch selectivity with the semiconductor material of substrate 201. In some examples, sacrificial plugs 204 include titanium nitride (TiN) or titanium oxide (TiO₂). A top surface of substrate 201 may be polished following the formation of sacrificial plugs 204 using, for example, chemical mechanical polishing (CMP) to create a smooth, planar surface.

Figure 2C depicts the cross-section view of the structure shown in Figure 2B along with another substrate being bonded to substrate 201, according to an embodiment of the present disclosure. A second substrate 206 having a dielectric layer 208 is bonded to the surface of substrate 201 using direct wafer bonding, surface activated bonding, or plasma activated bonding, to name a few examples. In any case, dielectric layer 208 forms a strong bond with the semiconductor surface of substrate 201. Second substrate 206 may have the same semiconductor material as substrate 201, such as silicon or silicon germanium. Dielectric layer 208 may include an oxide of the semiconductor material used in substrate 201 and/or second substrate 206. For example, dielectric layer 208 may be silicon oxide. Dielectric layer 208 may have a thickness between about 10 nm and about 20 nm.

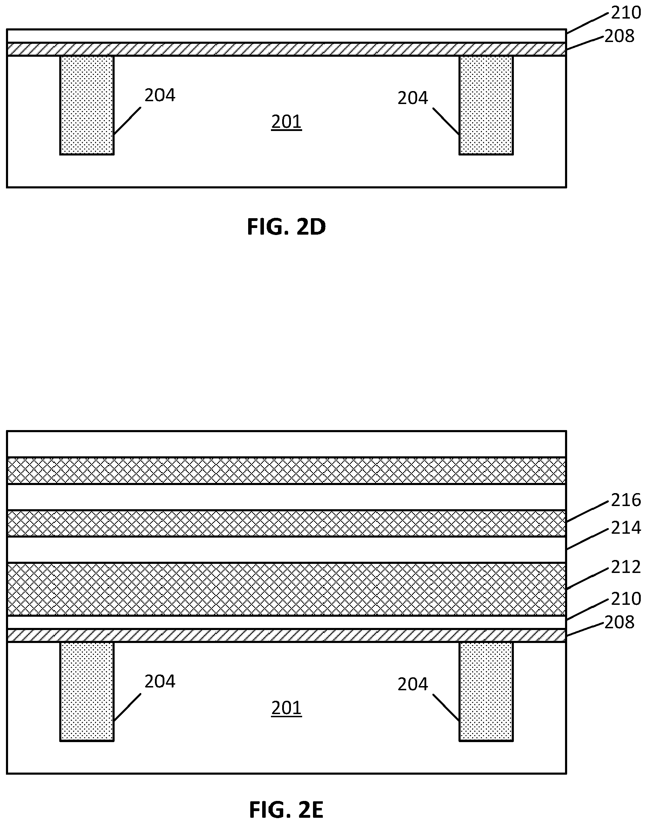

Figure 2D depicts the cross-section view of the structure shown in Figure 2C following the bonding of the substrates and the removal of a bulk portion of the second substrate, according to an embodiment of the present disclosure. A majority of the second substrate 206 may be removed using, for example, a long CMP process or a vapor-phase etchant to remove a bulk portion of second substrate 206, thus leaving behind a thin semiconductor layer 210. For example, second substrate 206 may have a thickness of several hundreds of micrometers while the remaining semiconductor layer 210 has a thickness between about 10 nm and about 30 nm. According to some embodiments, second wafer 206 has a single-crystal lattice structure and thus semiconductor layer 210 has the same single-crystal lattice structure. Following the removal of the bulk of second substrate 206, dielectric layer 208 and semiconductor layer 210 have effectively been transferred onto the top surface of substrate 201.

Figure 2E illustrates a cross-sectional view of the structure shown in Figure 2D following the formation of a series of material layers over the substrate, according to an embodiment of the present disclosure. Alternating material layers may be deposited over substrate 201 (and over both dielectric layer 208 and semiconductor layer 210), including a spacer layer 212, and semiconductor layers 214 alternating with sacrificial layers 216. Any number of alternating semiconductor layers 214 and sacrificial layers 216 may be deposited over spacer layer 212. It should be noted that the cross section illustrated in Figure 2E is taken along the length of a fin formed from the multiple layers and extending up above the surface of substrate 201.

According to some embodiments, spacer layer 212 and sacrificial layers 216 have a different material composition than semiconductor layers 214. In some embodiments, spacer layer 212 and sacrificial layers 216 are silicon germanium (SiGe) while semiconductor layers 214 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 216 and in semiconductor layers 214, the germanium concentration is different between sacrificial layers 216 and semiconductor layers 214. For example, sacrificial layers 216 may include a higher germanium content compared to semiconductor layers 214. Semiconductor layers 214 may be doped with either n-type dopants (to produce a p-channel transistor) or p-type dopants (to produce an n-channel transistor). Spacer layer 212 may include the same material as sacrificial layers 216. In some examples, spacer layer 212 can be any material that exhibits a high etch selectivity with the material of semiconductor layers 214.

While dimensions can vary from one example embodiment to the next, the thickness of each sacrificial layer 216 may be between about 5 nm and about 20 nm. In some embodiments, the thickness of each sacrificial layer 216 is substantially the same (e.g., within 1-2 nm). The thickness of each of semiconductor layers 214 may be about the same as the thickness of each sacrificial layer 216 (e.g., about 5-20 nm). However, according to some embodiments, the thickness of spacer layer 212 is thicker than any of sacrificial layers 216. Spacer layer 212 may be provided to create a sufficient spacing between the semiconductor layers 214 of the semiconductor device and any portion of semiconductor layer 210. While dimensions can vary from one example embodiment to the next, the thickness of spacer layer 212 may be between about 30 nm to about 80 nm. In some other embodiments, spacer layer 212 has substantially the same thickness as any sacrificial layer 216 such that spacer layer 212 is effectively the same as any other sacrificial layer 216 in the stack. Each of sacrificial layers 216, semiconductor layers 214, and spacer layer 212 may be deposited using any known material deposition technique, such as chemical vapor deposition (CVD), plasma-enhanced chemical vapor deposition (PECVD), physical vapor deposition (PVD), or atomic layer deposition (ALD).

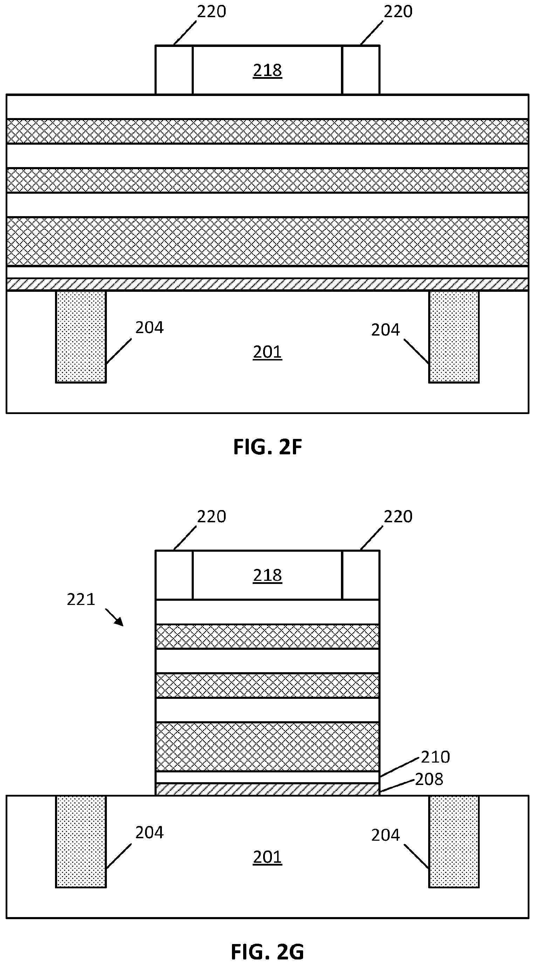

Figure 2F illustrates a cross-sectional view of the structure shown in Figure 2E following the formation of a sacrificial gate structure 218 and sidewall spacers 220 over the alternating layer structure of the fin, according to an embodiment. Sacrificial gate structure 218 may run in an orthogonal direction to the length of the fin and may include any material that can be safely removed later in the process without etching or otherwise damaging any portions of the fin or of spacer structures 220. In some embodiments, sacrificial gate structure 218 includes polysilicon. Spacer structures 220 may be formed using an etch-back process where spacer material is deposited everywhere and then anisotropically etched to leave the material only on sidewalls of structures including sacrificial gate structure 218. Spacer structures 220 may include a dielectric material, such as silicon nitride, silicon oxy-nitride, or any formulation of those layers incorporating carbon or boron dopants. Sacrificial gate structure 218 together with spacer structures 220 define a portion of the fin that will be used to form a GAA semiconductor device discussed further herein.

Figure 2G illustrates a cross-sectional view of the structure shown in Figure 2F following the removal of the exposed fin not under sacrificial gate structure 218 and sidewall spacers 220, according to an embodiment of the present disclosure. According to some embodiments, the various layers of the different layer stacks are etched at substantially the same rate using an anisotropic RIE process, or other suitable directional etch. In some embodiments, some undercutting occurs along the edges of the resulting fin 221 beneath spacer structures 220 such that the length of fin 221 is not exactly the same as a sum of the widths of spacer structures 220 and a width of sacrificial gate structure 218. The RIE process may also etch into substrate 201 thus recessing portions of substrate 201 on either side of fin 221. For example, portions of both dielectric layer 208 and semiconductor layer 210 may be removed by the RIE process. The removal of the portions of dielectric layer 208 and semiconductor layer 210 exposes top surfaces of dielectric plugs 204, according to some embodiments. In some cases, the RIE process may also etch into substrate 201 thus recessing portions of substrate 201 around dielectric plugs 204, so as to expose side surfaces of plugs 204.

Figure 2H illustrates a cross-sectional view of the structure shown in Figure 2G following the removal of portions of sacrificial layers 216 and spacer layer 212, according to an embodiment of the present disclosure. An isotropic etching process may be used to recess the exposed ends of each sacrificial layer 216 and spacer layer 212.

Figure 21 illustrates a cross-sectional view of the structure shown in Figure 2H following the formation of internal spacers 222, according to an embodiment of the present disclosure. Internal spacers 222 may have a material composition that is similar to or the exact same as spacer structures 220. Accordingly, internal spacers 220 may be any suitable dielectric material that exhibits high etch selectively to semiconductor materials such as silicon and/or silicon germanium. Internal spacers 222 may be conformally deposited over the sides of the fin structure using a CVD process like ALD and then etched back using an isotropic etching process to expose the ends of semiconductor layers 214.

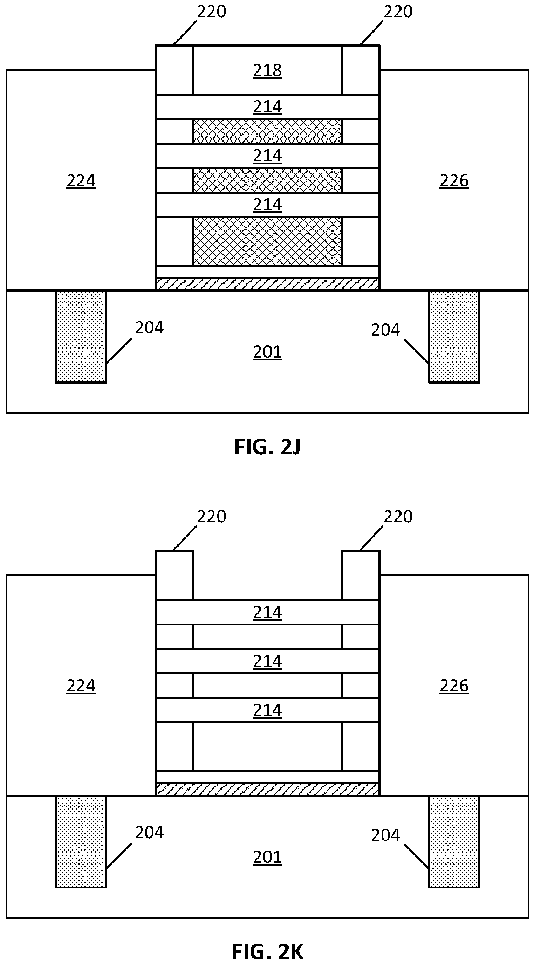

Figure 2J illustrates a cross-sectional view of the structure shown in Figure 21 following the formation of source and drain regions, according to an embodiment of the present disclosure. According to an embodiment, a source region 224 and a drain region 226 are formed at either ends of semiconductor layers 214. In some examples, source and drain regions 224/226 are epitaxially grown from the ends of semiconductor layers 214. Any semiconductor materials suitable for source and drain regions 224/226 can be used (e.g., group IV and group III-V semiconductor materials). Source and drain regions 224/226 may include multiple layers such as liners and capping layers to improve contact resistance. In any such cases, the composition and doping of source and drain regions 224/226 may be the same or different, depending on the polarity of the transistor. In one example, semiconductor layers 214 are doped with n-type dopants and source and drain regions 224/226 include a high concentration of p-type dopants (PMOS transistor). In another example, semiconductor layers 214 are doped with p-type dopants and source and drain regions 224/226 include a high concentration of n-type dopants (NMOS transistor). Any number of source and drain configurations and materials can be used. Recall from the discussion of Figure 2G that, in some embodiments, sidewalls of plugs 204 are exposed during the earlier etch process to form the source and drain trenches. In some such cases, source and drain regions 224/226 are both on top of the plugs as well as around at least a portion of plugs 204. In still other cases, note that source and drain regions 224/226 may not fully align with plugs 204, such that one or both of source and drain regions 224/226 may be only partially landed on their respective plugs, according to some examples.

Figure 2K illustrates a cross-sectional view of the structure shown in Figure 2J following the removal of the sacrificial gate structure 218, sacrificial layers 216, and spacer layer 212, according to an embodiment of the present disclosure. Sacrificial gate structure 218 may be removed using any wet or dry isotropic process thus exposing the alternating layer stack of the fin within the trench left behind after the removal of sacrificial gate structure 218. Once sacrificial gate structure 218 has been removed, sacrificial layers 216 and spacer layer 212 may also be removed using a selective isotropic etching process that removes the material of sacrificial layers 216 and spacer layer 212 but does not remove (or removes very little of) semiconductor layers 214. At this point, the suspended semiconductor layers 214 form nanoribbons or nanowires that extend between source and drain regions 224/226.

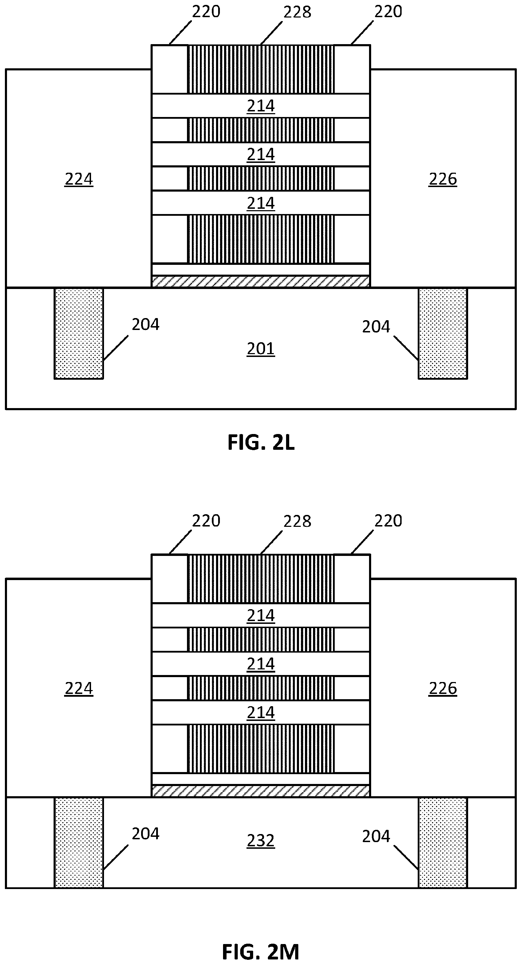

Figure 2L illustrates a cross-sectional view of the structure shown in Figure 2K following the formation of a gate structure 228 around the suspended semiconductor layers 214, according to an embodiment of the present disclosure. As noted above, gate structure 228 includes a gate dielectric and a gate electrode.

The gate dielectric may be conformally deposited around semiconductor layers 214 using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on first and second semiconductor layers 214, and a second layer on the first layer. The first layer can be, for instance, an oxide of the semiconductor layers 214 (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-K material can be nitridized to improve its aging resistance.

The gate electrode may be deposited over the gate dielectric and can be any standard or proprietary gate structure that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Figure 2M depicts the cross-section view of the structure shown in Figure 2L following the removal of substrate 201 and formation of base dielectric layer 232, according to an embodiment of the present disclosure. Following the formation of various front-side contacts and interconnects (e.g., FEOL structures), a bulk portion of substrate 201 is removed until sacrificial plugs 204 are exposed from the backside, according to some embodiments. The bulk portion of substrate 201 may be removed using, for example, CMP or vapor phase etchants. According to some embodiments, once substrate 201 has been thinned to about the same thickness as sacrificial plugs 204, the remaining portion of substrate 201 coplanar with sacrificial plugs 204 is removed using, for example, an isotropic etching process. This leaves sacrificial plugs 204 extending outward from the backside of the device. A dielectric material may then be deposited over and around sacrificial plugs 204 and polished back to once again expose sacrificial plugs 204 and form base dielectric layer 232. As noted above, any suitable dielectric material may be used for base dielectric layer 232, with some examples including silicon dioxide, aluminum oxide, or silicon oxycarbonitride. Recall from the discussion of Figure 2J that, in some embodiments, source and drain regions 224/226 are both on top of plugs 204 as well as around at least a portion of the sidewalls of plugs 204. Such a configuration may help stabilize plugs 204 during this process where substrate 201 is removed and replaced by base dielectric layer 232.

Figure 2N depicts the cross-section view of the structure shown in Figure 2M following the formation of backside contacts, according to an embodiment of the present disclosure. Following the formation of base dielectric layer 232, sacrificial plugs 204 are removed and replaced with backside conductive contacts 230, according to some embodiments. Backside conductive contacts 230 can be any conductive material, such as any metal or metal alloy, that may include any of tungsten, molybdenum, ruthenium, cobalt, copper, aluminum, or silver. Backside interconnect structures may then be formed to connect with any of conductive contacts 230 to route signal or power to source 224 and/or drain 226.

In another example embodiment, the backside conductive contacts 230 can be formed before deposition of the base dielectric layer 232. In one such case, for instance, a bulk portion of substrate 201 is removed until sacrificial plugs 204 are exposed from the backside, and at this point plugs 204 can be removed and replaced with backside conductive contacts 230. A planarization process (e.g., CMP) can remove any excess conductive material 230, down to the tops of backside conductive contacts 230. The remaining portion of substrate 201 coplanar with the tops of backside conductive contacts 230 can then be removed using, for example, an isotropic etching process. Base dielectric layer 232 can then be deposited and planarized so as to be coplanar with the tops of backside conductive contacts 230. Other variations will be apparent in light of this disclosure.

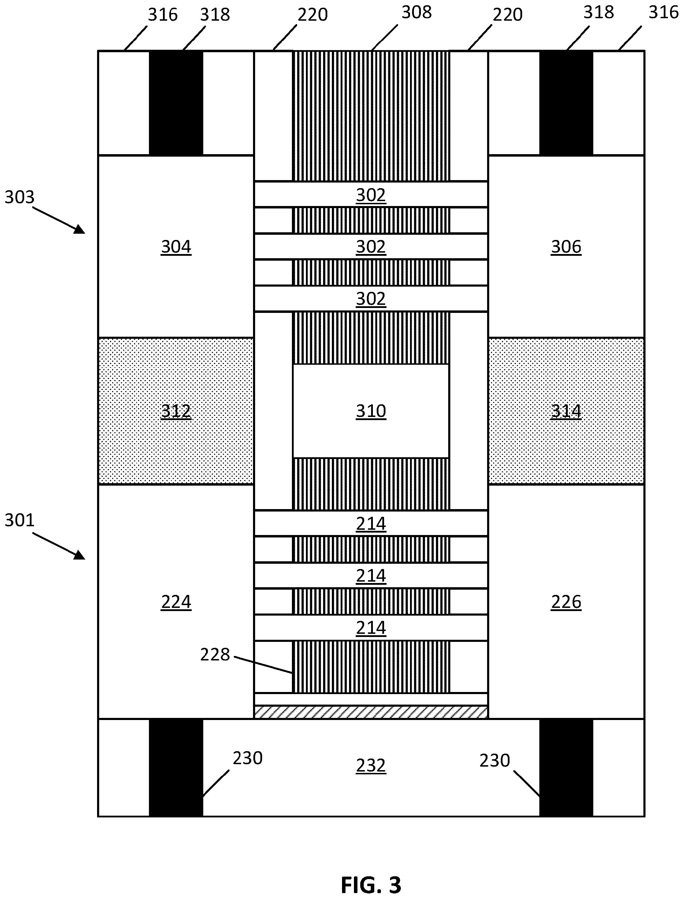

The example structures in Figures 2A - 2N have a 2D architecture (non-stacked semiconductor devices), however, according to some other embodiments, similar processing can be used to provide semiconductor devices stacked over one another in a vertical direction to provide upper and lower devices arranged in 3D architecture to further increase device density, such as shown in Figure 3. For such structures, contacts can be made to components of the top device and separately to components of the bottom device. Backside contacts are thus useful for providing the contacts to the bottom device, according to some embodiments.

Figure 3 illustrates an example portion of an integrated circuit that includes a first semiconductor device 301 and a second semiconductor device 303 stacked vertically over first semiconductor 301, according to an embodiment. First semiconductor device 301 may be similar to the semiconductor device shown at the end of fabrication process in Figure 2N and thus incudes many of the same labels. Second semiconductor device 303 may similarly have a GAA structure with one or more semiconductor nanoribbons 302 extending between a source 304 and a drain 306.

A second gate structure 308 is formed around semiconductor nanoribbons 302, which is isolated from gate structure 228 by a gate isolation layer 310 within spacer structures 220. Second gate structure 308 may be similar to gate structure 228 in that second gate structures 308 includes one or more gate dielectric layers and one or more gate electrode layers over the one or more gate dielectric layers. In one example, gate structure 228 and second gate structure 308 include the same gate dielectric and gate electrode fill metal (if any) but include different workfunction materials in their respective gate electrodes. For instance, one of the upper or lower gate electrode may include a p-type workfunction material (e.g., titanium nitride) and the other of the upper or lower gate electrode may include an n-type workfunction material (e.g., titanium aluminum carbide). The isolation layer 310 can be any suitable dielectric material, such as silicon oxide, and may be the same material, for instance, as other insulating layers 312 and/or 314 that respectively separate source region 304 from source region 224 and drain region 306 from drain region 226. In some cases, the various layers of gate structure 228 are deposited on both the lower and upper channel regions (e.g., over nanoribbons 214 and 302), followed by an etch-back process to remove those layers from the upper channel region. Then, isolation layer 310 can be deposited within the gate trench on top of gate structure 228 and recessed to a desired level. Then the various layers of second gate structure 308 can be deposited.

Another dielectric layer 316 may be formed over the topside of each of source 304 and drain 306 with topside contacts 318 being formed to make electrical contact with each of source 304 and drain 306. Accordingly, backside conductive contacts 230 provide electrical connection to source 224 and drain 226 of first semiconductor device 301 while topside contacts 318 provide electrical connection to source 304 and drain 306 of second semiconductor device 303. Additional topside interconnect structures may be formed to connect with any of topside contacts 318 to route signal or power to source 304 and/or drain 306.

Note that in a gate-last process, the dielectric layer 316 and contacts 318 can be formed prior to forming first gate structure 228 and second gate structure 308. Further note that in some examples, gate structure 308 can be frontside connected and gate structure 228 can be backside connected. In some such cases, one or more remnants of layers 208 and/or 210 may remain (e.g., under gate spacer 220 on one or both sides). Further note that, in other embodiments, a single monolithic gate structure can be formed around semiconductor nanoribbons 302 and semiconductor nanoribbons 214. In such example, there is no isolation layer 310. In addition, in some such cases, the upper electrode portion around nanoribbons 302 may have a different workfunction than the lower electrode portion around nanoribbons 214. So, even if a monolithic gate structure is used, upper and lower portions of that gate structure can be different to enhance gate performance.

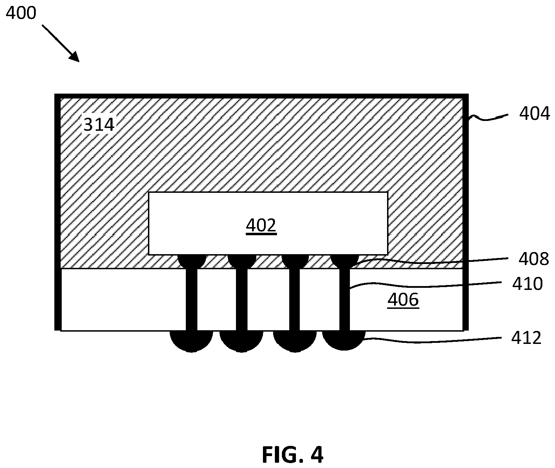

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

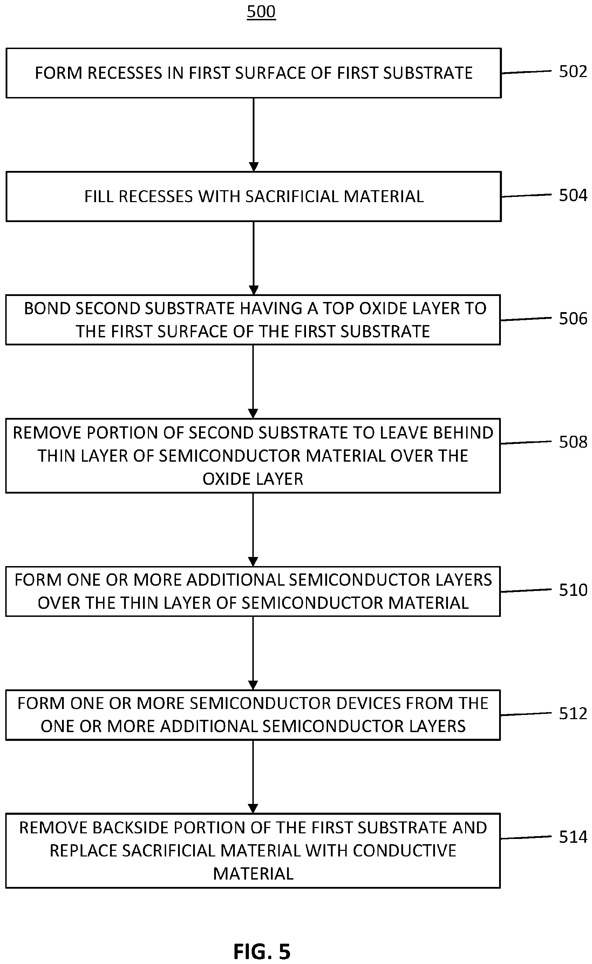

Figure 5 is a flow chart of a method 500 for forming at least a portion of an integrated circuit, according to an embodiment. Various operations of method 500 may be illustrated in Figures 2A - 2N. However, the correlation of the various operations of method 500 to the specific components illustrated in the aforementioned figures is not intended to imply any structural and/or use limitations. Rather, the aforementioned figures provide one example embodiment of method 500. Other operations may be performed before, during, or after any of the operations of method 500. For example, method 500 does not explicitly describe many steps that are performed to form common transistor structures. Some of the operations of method 500 may be performed in a different order than the illustrated order.

Method 500 begins with operation 502 where recesses are formed in the top surface of a first substrate. The recesses are formed in locations where the backside contacts will later be formed. Accordingly, the recesses may have a pitch dependent on a desired transistor gate length, such as between 50 nm and 100 nm. While dimensions can vary from one example embodiment to the next, a depth of a given recess may be between about 30 nm and about 100 nm while a width of a given recess may be between about 20 nm and about 50 nm.

Method 500 continues with operation 504 where the recesses are filled with sacrificial material. The sacrificial material forms sacrificial plugs within the recesses. The sacrificial plugs may include any material that can be selectively removed with regards to the material of the first substrate. In some examples, the sacrificial plugs include titanium nitride (TiN) or titanium oxide (TiO₂).

Method 500 continues with operation 506 where a second substrate is bonded over the top surface of the first substrate. The second substrate includes a top dielectric layer that forms the bond with the first substrate. Accordingly, the bond between the dielectric layer and, for example, a semiconductor material of the first substrate may be formed using direct wafer bonding, surface activated bonding, or plasma activated bonding, to name a few examples. In some embodiments, both the second substrate and the first substrate include the same semiconductor material, such as silicon or silicon germanium. The dielectric layer may be silicon oxide and may have a thickness between about 10 nm and about 20 nm.

Method 500 continues with operation 508 where a portion of the second substrate is removed to leave behind a thin semiconductor layer over the oxide layer. A majority of the second substrate may be removed using, for example, a long CMP process or a vapor-phase etchant to remove a bulk portion of the second substrate. For example, the second substrate may have an initial thickness of several hundreds of micrometers while the remaining thin semiconductor layer following the removal of a bulk of the substrate has a thickness between about 10 nm and about 30 nm. According to some embodiments, the second substrate has a single-crystal lattice structure and thus the remaining thin semiconductor layer has the same single-crystal lattice structure. Following the removal of the bulk of the second substrate, the dielectric layer and the thin semiconductor layer have effectively been transferred onto the top surface of the first substrate.

Method 500 continues with operation 510 where one or more additional semiconductor layers are formed over the thin semiconductor layer. In some embodiments, a single semiconductor layer is epitaxially grown over the thin semiconductor layer to facilitate the formation of finFET structures. In some embodiments, multiple different semiconductor layers are grown sequentially over the thin semiconductor layer to facilitate the formation of GAA or forksheet structures. For example, alternating material layers may be deposited that include sacrificial layers alternating the semiconductor layers. Any number of alternating semiconductor layers and sacrificial layers may be formed. In some embodiments, the semiconductor layers include silicon while the sacrificial layers include silicon and germanium.

Method 500 continues with operation 512 where one or more semiconductor devices are formed from the one or more additional semiconductor layers. As noted above, the semiconductor devices can include any of finFET, GAA, or forksheet devices, to name a few examples. Such devices include one or more semiconductor layers extending between a source and drain region to form transistors. According to some embodiments, any of the source or drain regains are formed over corresponding sacrificial plugs within the first substrate.

Method 500 continues with operation 514 where a backside portion of the first substrate is removed, and the sacrificial plugs are replaced with conductive material to form backside conductive contacts. A bulk portion of the first substrate is removed until the sacrificial plugs are exposed from the backside, according to some embodiments. The bulk portion of first substrate may be removed using, for example, CMP or vapor phase etchants. Once the substrate has been thinned to about the same thickness as sacrificial plugs, the remaining portion of the substrate coplanar with the sacrificial plugs is removed using, for example, an isotropic etching process. A dielectric material may then be deposited over and around the exposed sacrificial plugs and polished back to once again expose the sacrificial plugs.

The sacrificial plugs may then be removed and replaced with backside conductive contacts, according to some embodiments. The backside conductive contacts can be any conductive material, such as any metal or metal alloy, that may include any of tungsten, molybdenum, ruthenium, cobalt, copper, aluminum, or silver. Backside interconnect structures may then be formed to connect with any of the backside conductive contacts to route signal or power to any of the source regions or drain regions of the various semiconductor devices.

### Example System

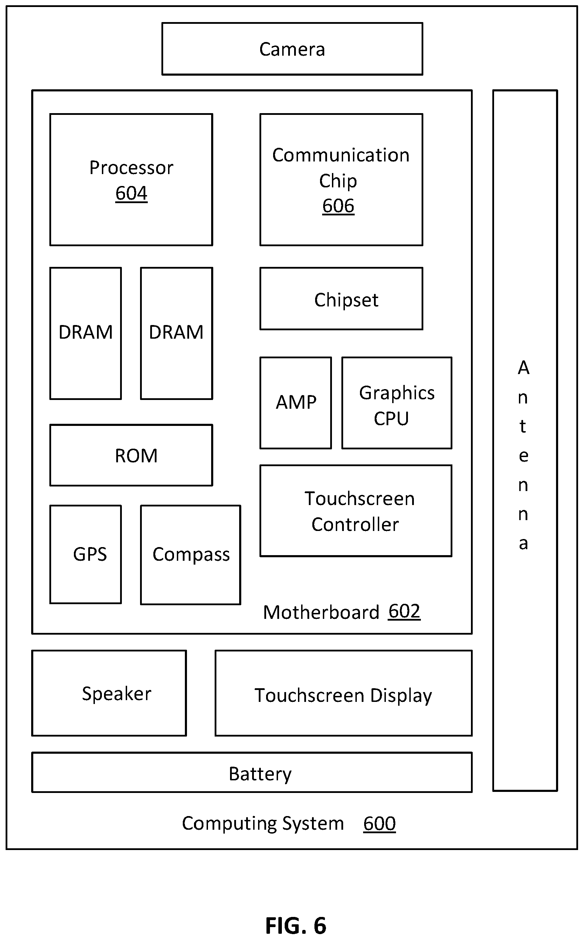

Figure 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment (e.g., a module including an integrated circuit on a substrate, the substrate having semiconductor devices exhibiting a multi-layer structure in the sub fin region, as variously provided herein). In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a base dielectric layer and a semiconductor device over the base dielectric layer that includes a semiconductor material extending between a source region and a drain region, and a sub fin beneath the semiconductor material. The integrated circuit further includes a first dielectric layer adjacent to the sub fin of the semiconductor device and a conductive contact in the base dielectric layer. The conductive contact contacts the source region or the drain region from beneath the source region or the drain region. The sub fin includes a semiconductor layer over a second dielectric layer.

Example 2 includes the subject matter of Example 1, wherein the semiconductor material comprises one or more semiconductor nanoribbons.

Example 3 includes the subject matter of Example 2, wherein the one or more semiconductor nanoribbons comprise germanium, silicon, or both.

Example 4 includes the subject matter of Example 1, wherein the semiconductor material comprises a fin shape that extends above a top surface of the first dielectric layer.

Example 5 includes the subject matter of any one of Examples 1-4, wherein the semiconductor layer comprises a same material as the semiconductor material.

Example 6 includes the subject matter of any one of Examples 1-5, wherein the semiconductor layer is a single-crystalline semiconductor material.

Example 7 includes the subject matter of any one of Examples 1-6, wherein the source region or the drain region contacts the second dielectric layer and the semiconductor layer.

Example 8 includes the subject matter of any one of Examples 1-7, wherein the second dielectric layer has a thickness between about 10 nm and about 20 nm, and the semiconductor layer has a thickness between about 10 nm and about 30 nm.

Example 9 includes the subject matter of any one of Examples 1-8, comprising a gate structure at least partially around the semiconductor material.

Example 10 is a printed circuit board comprising the integrated circuit of any one of Examples 1-9.

Example 11 is an electronic device that includes a chip package comprising one or more dies. At least one of the one or more dies includes a semiconductor device having a semiconductor material extending between a source region and a drain region, and a sub fin beneath the semiconductor material. The at least one of the one or more dies further includes a first dielectric layer adjacent to the sub fin of the semiconductor device, and a conductive contact in contact with the source region or the drain region from beneath the source region or the drain region. The sub fin includes a semiconductor layer over a second dielectric layer.

Example 12 includes the subject matter of Example 11, wherein the semiconductor material comprises one or more semiconductor nanoribbons.

Example 13 includes the subject matter of Example 12, wherein the one or more semiconductor nanoribbons comprise germanium, silicon, or both.

Example 14 includes the subject matter of Example 11, wherein the semiconductor material comprises a fin shape that extends above a top surface of the first dielectric layer.

Example 15 includes the subject matter of any one of Examples 11-14, wherein the conductive contact is in a base dielectric layer beneath the semiconductor device and wherein at least a portion of the sub fin is formed from the base dielectric layer.

Example 16 includes the subject matter of any one of Examples 11-15, wherein the semiconductor layer is a single-crystalline semiconductor material.

Example 17 includes the subject matter of any one of Examples 11-16, wherein the source region or the drain region contacts the second dielectric layer and the semiconductor layer.

Example 18 includes the subject matter of any one of Examples 11-17, wherein the second dielectric layer has a thickness between about 10 nm and about 20 nm, and the semiconductor layer has a thickness between about 10 nm and about 30 nm.

Example 19 includes the subject matter of any one of Examples 11-18, further comprising a printed circuit board, wherein the chip package is attached to the printed circuit board.

Example 20 includes the subject matter of any one of Examples 11-19, comprising a gate structure at least partially around the semiconductor material.

Example 21 is an integrated circuit that includes a first semiconductor device and a second semiconductor device located vertically over the first semiconductor device. The first semiconductor device includes a first semiconductor material extending between a first source region and a first drain region, a sub fin beneath the first semiconductor material and including a semiconductor layer over a dielectric layer, and a first gate structure around the first semiconductor material. The second semiconductor device includes a second semiconductor material extending between a second source region and a second drain region, and a second gate structure around the second semiconductor material. The integrated circuit further includes a gate isolation layer between the first gate structure and the second gate structure, a first conductive contact in contact with the first source region or the first drain region from beneath the first source region or the first drain region, and a second conductive contact in contact with the second source region or the second drain region from above the second source region or the second drain region.

Example 22 includes the subject matter of Example 21, wherein the first semiconductor material and the second semiconductor material each comprises one or more semiconductor nanoribbons.

Example 23 includes the subject matter of Example 21 or 22, wherein the semiconductor layer is a single-crystalline semiconductor material.

Example 24 includes the subject matter of any one of Examples 21-23, wherein the first source region or the first drain region contacts the dielectric layer and the semiconductor layer.

Example 25 includes the subject matter of any one of Examples 21-24, wherein the dielectric layer has a thickness between about 10 nm and about 20 nm, and the semiconductor layer has a thickness between about 10 nm and about 30 nm.

Example 26 is a method of forming an integrated circuit. The method includes forming one or more recesses into a first surface of a first substrate; forming a sacrificial material within the one or more recesses to form one or more material plugs; providing a second substrate having a semiconductor material and an oxide layer on a top surface of the second substrate; bonding the second substrate to the first substrate by forming a bond between the oxide layer and the first surface of the first substrate; removing a portion of the second substrate such that only the oxide layer and a single layer of the semiconductor material on the oxide layer remains, the single layer of semiconductor material having a thickness of less than 100 nm; forming one or more additional layers of semiconductor material over the single layer of semiconductor material; and etching one or more recesses through the one or more additional layers and the single layer of semiconductor material, wherein a given recess of the one or more recesses exposes a corresponding material plug of the one or more material plugs.

Example 27 includes the subject matter of Example 26, further comprising forming a source region or a drain region in the given recess, wherein the source region or drain region contacts the corresponding material plug.

Example 28 includes the subject matter of Example 27, further comprising: removing a backside portion of the first substrate to expose the one or more material plugs; removing the sacrificial material from the one or more recesses; and forming a conductive material within the one or more recesses.

Example 29 includes the subject matter of Example 28, wherein the conductive material within the given recess contacts the source region or drain region.

Example 30 includes the subject matter of any one of Examples 26-29, wherein forming one or more additional layers of semiconductor material comprises forming alternating layers of a first semiconductor material and a second semiconductor material.

Example 31 includes the subject matter of Example 30, wherein the first semiconductor material comprises silicon, and the second semiconductor material comprises silicon and germanium.

Example 32 includes the subject matter of any one of Examples 26-31, wherein the single layer of semiconductor material is a single-crystalline semiconductor material.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a base dielectric layer;
a semiconductor device over the base dielectric layer and including
a semiconductor material extending between a source region and a drain region, and
a sub fin beneath the semiconductor material;
a first dielectric layer adjacent to the sub fin of the semiconductor device; and
a conductive contact in the base dielectric layer and contacting the source region or the drain region from beneath the source region or the drain region;
wherein the sub fin includes a semiconductor layer over a second dielectric layer.

2. The integrated circuit of claim 1, wherein the semiconductor material comprises one or more semiconductor nanoribbons.

3. The integrated circuit of claim 2, wherein the one or more semiconductor nanoribbons comprise germanium, silicon, or both.

4. The integrated circuit of claim 1, wherein the semiconductor material comprises a fin shape that extends above a top surface of the first dielectric layer.

5. The integrated circuit of claim 1, wherein the semiconductor layer comprises a same material as the semiconductor material.

6. The integrated circuit of claim 1, wherein the semiconductor layer is a single-crystalline semiconductor material.

7. The integrated circuit of claim 1, wherein the source region or the drain region contacts the second dielectric layer and the semiconductor layer.

8. The integrated circuit of claim 1, wherein the second dielectric layer has a thickness between about 10 nm and about 20 nm, and the semiconductor layer has a thickness between about 10 nm and about 30 nm.

9. The integrated circuit of claim 1, comprising a gate structure at least partially around the semiconductor material.

10. A printed circuit board comprising the integrated circuit of claim 1.

11. An integrated circuit comprising:
a first semiconductor device including
a first semiconductor material extending between a first source region and a first drain region,
a sub fin beneath the first semiconductor material and including a semiconductor layer over a dielectric layer, and
a first gate structure around the first semiconductor material;
a second semiconductor device located vertically over the first semiconductor device and including
a second semiconductor material extending between a second source region and a second drain region, and
a second gate structure around the second semiconductor material;
a gate isolation layer between the first gate structure and the second gate structure;
a first conductive contact in contact with the first source region or the first drain region from beneath the first source region or the first drain region; and
a second conductive contact in contact with the second source region or the second drain region from above the second source region or the second drain region.

12. The integrated circuit of claim 11, wherein the first semiconductor material and the second semiconductor material each comprises one or more semiconductor nanoribbons.

13. The integrated circuit of claim 11 or 12, wherein the semiconductor layer is a single-crystalline semiconductor material.

14. The integrated circuit of any one of claims 11 through 13, wherein the first source region or the first drain region contacts the dielectric layer and the semiconductor layer.

15. The integrated circuit of any one of claims 11 through 14, wherein the dielectric layer has a thickness between about 10 nm and about 20 nm, and the semiconductor layer has a thickness between about 10 nm and about 30 nm.
